# EUROPEAN PATENT APPLICATION

(11) **EP 3 958 263 A1**
(43) Date of publication of application: **23.02.2022**
(21) Application number: 21189697.2
(22) Date of filing: 04.08.2021
(51) Int. Cl.: G11C 11/406, G11C 29/52, G06F 11/10, G11C 5/04, G11C 7/04, G11C 29/02, G11C 29/04

(54) **MEMORY CONTROLLER WITH ADAPTIVE REFRESH RATE CONTROLLED BY ERROR BIT INFORMATION**

(30) Priority: 17.08.2020 US 202063066363 P; 15.07.2021 US 202117377350
(71) Applicant: MediaTek Inc., Hsin-Chu 300 (TW)
(72) Inventor: HUANG, Hsiang-I, 30078 Hsinchu City (TW)
(74) Representative: Haseltine Lake Kempner LLP

(57) **Abstract**

The present invention provides a memory controller including a decoder, an error bit counter and a refresh rate control circuit. The decoder is configured to receive and decode data from a memory module to generate decoded data. The error counter is coupled to the decoder, and is configured to generate error bit information of the data. The refresh rate control circuit is coupled to the error counter, and is configured to determine a refresh rate of the memory module according to the error bit information.

## Description

This application claims the priority of US Provisional Application No. 63/066,363 (filed on August 17th, 2020), which is included herein by reference in its entirety.

### Background

Dynamic random access memory (DRAM) is a storage device widely used in electronic devices, which can temporarily store large amount of data. The performance of DRAM will greatly affect the performance of the overall system, specifically, reliability of DRAM is critical to system stability, DRAM bandwidth is critical to system performance, and DRAM power is critical to power consumption of system. In addition, DRAM cells need to be periodically refreshed to prevent data loss due to leakage current, and a refresh rate may influence the reliability of DRAM (e.g., bit error rate) significantly, for example, if the DRAM has higher refresh rate, the DRAM may have lower bit error rate and higher reliability. However, higher refresh rate may increase DRAM power and reduce DRAM bandwidth.

To determine the appropriate refresh rate, a temperature-controlled refresh rate is provided, that is the refresh rate is determined based on the current temperature of DRAM. However, the temperature is not the only factor that affects the required refresh rate. The semiconductor process variation, power noise and alpha particle effect may also affect the reliability of DRAM, that is, these factors also need to be considered for the determination of the required refresh rate. In addition, the required refresh rate is varied from die to die and from system to system, and the conventional mechanism may be too optimistic about the actual required refresh rate so that the bit error rate of the DRAM may be higher than expected, or the conventional mechanism may be too pessimistic about the actual required refresh rate so that the DRAM power and DRAM bandwidth may be wasted.

### Summary

It is therefore an objective of the present invention to provide a method for adaptive control the refresh rate according to the observed bit error rate, to solve the above-mentioned problems.

According to one embodiment of the present invention, a memory controller comprising a decoder, an error bit counter and a refresh rate control circuit is disclosed. The decoder is configured to receive and decode data from a memory module to generate decoded data. The error counter is coupled to the decoder, and is configured to generate error bit information of the data. The refresh rate control circuit is coupled to the error counter, and is configured to determine a refresh rate of the memory module according to the error bit information.

According to another embodiment of the present invention, a control method of a memory system comprises the steps of: receiving data from a memory module; decoding the data to generate decoded data; generating error bit information according to the data and the decoded data; and determining a refresh rate of the memory module according to the error bit information.

According to another embodiment of the present invention, a memory system comprising a memory module and a memory controller is disclosed, wherein the memory controller comprises a decoder, an error bit counter and a refresh rate control circuit. The decoder is configured to receive and decode data from the memory module to generate decoded data. The error counter is coupled to the decoder, and is configured to generate error bit information of the data. The refresh rate control circuit is coupled to the error counter, and is configured to determine a refresh rate of the memory module according to the error bit information.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a memory system according to one embodiment of the present invention.
FIG. 2 shows the control circuit according to one embodiment of the present invention.
FIG. 3 is a flowchart of a control method of the memory system according to one embodiment of the present invention.

### Detailed Description

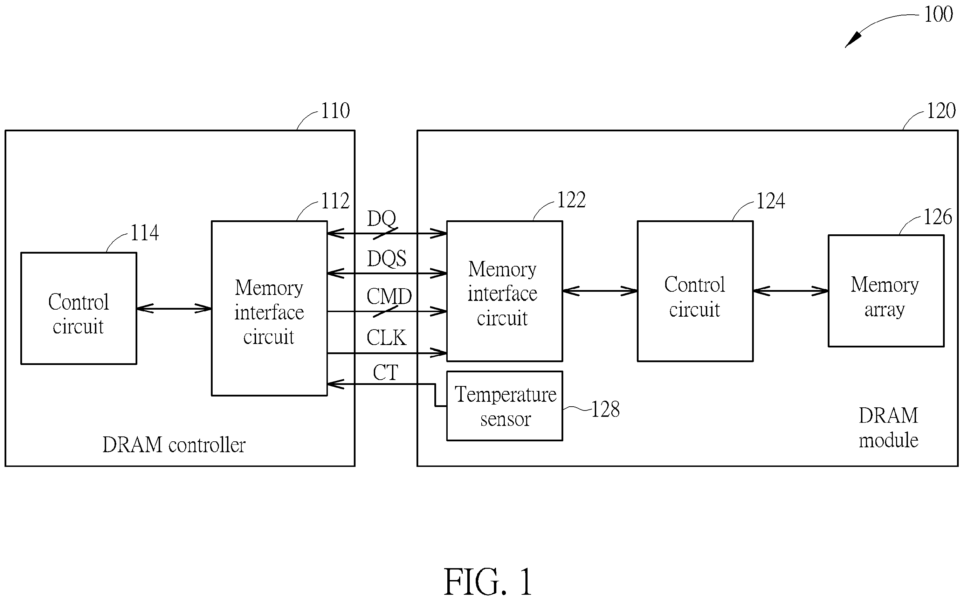

FIG. 1 is a diagram illustrating a memory system 100 according to one embodiment of the present invention. As shown in FIG. 1, the memory system 100 comprises a memory controller (in this embodiment, a DRAM controller 110 serve as the memory controller) and a memory module (in this embodiment, a DRAM module 120 serves as the memory module), where the DRAM controller 110 comprises a memory interface circuit 112 and a control circuit 114, and the DRAM module 120 comprises a memory interface circuit 122, a control circuit 124, a memory array 126 and a temperature sensor 128. In this embodiment, the DRAM controller 110 and the DRAM module 120 are connected via a plurality of connection lines, where the connection lines are used to transmit at least a plurality of a bi-directional data signal DQ, a bi-directional data strobe signal DQS, a plurality of command signals CMDs, a differential clock signal CLK and a coded temperature CT.

When the memory system 100 is implemented by a DRAM system, the command signals may comprise at least a row address strobe, a column address strobe, and a write enable signal. In addition, the clock signal or the command signals shown in FIG. 1 can be single-directional or bi-directional.

In the general operations of the memory system 100, the DRAM controller 110 is arranged to receive a request from a host or a processor, and to transmit at least a portion of the data signal DQ, data strobe signal DQS, command signals CMDs, the clock signal CLK and the clock enable signal CKE to access the DRAM module 120. In addition, the control circuit 114 within the DRAM controller 110 may comprise associated circuits, such as a processing circuit, a write/read buffer, a control logic and an arbiter, to perform the related operations. The memory interface circuit 112 of the DRAM controller 110 is arranged to output the data signal DQ, data strobe signal DQS, command signals CMDs, the clock signal CLK to the DRAM module 120. The memory interface circuit 122 is arranged to receive the data signal DQ, data strobe signal DQS, command signals CMDs and the clock signal CLK from the DRAM controller 110, and to output the data to the DRAM controller 110 via the DQ connection lines. The control circuit 124 may comprise a read/write controller, a row decoder and a column decoder, and the control circuit 124 is arranged to receive output signals from the memory interface circuit 122 to access the memory array 126.

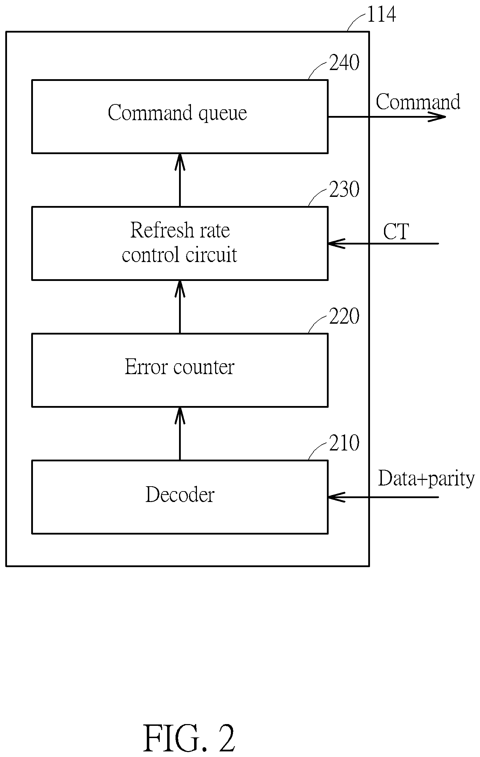

In this embodiment, in order to make the DRAM module 120 has an appropriate refresh rate, the control circuit 114 is designed to generate the refresh command according to bit error count or bit error rate of the data read from the DRAM module 120. Specifically, FIG. 2 shows the control circuit 114 according to one embodiment of the present invention. As shown in FIG. 2, the control circuit 114 comprises at least a decoder 210, an error counter 220, a refresh rate control circuit 230 and a command queue 240. The decoder 210 is configured to receive data and corresponding parity from the DRAM module 120, and to decode the data with the corresponding parity to generate decoded data, wherein the data and the corresponding parity may be read in response to a read command sent by the DRAM controller 110. In the process of decoding the data, the decoder 210 can know which bit has an error, and once the error bit(s) is/are found, the decoder 210 notifies the error counter 220. The error counter 220 is configured to generate error bit information to the refresh rate control circuit 230 according to the number of error bits found by the decoder 210, wherein the error bit information may be an accumulated number of error bits within a past period of time, or a bit error rate of the data. In addition, the error bit information may indicate the severity of the error bits, for example, the severity of the error bits may have four levels, and the error bit information indicates which level the current error bits belongs to.

The refresh rate control circuit 230 determines the appropriate refresh rate according to the error bit information of the error counter 220 and the coded temperature CT provided by the temperature sensor 128, wherein if the error bit information represents a greater accumulated error bits within a period of time or a higher bit error rate, for example, the accumulated error bits or the bit error rate is greater than a first threshold, the refresh rate control circuit 230 can determine a higher refresh rate to improve the reliability of the DRAM module 120; and if the error bit information represents a lower accumulated error bits within a period of time or a lower bit error rate, for example, the accumulated error bits or the bit error rate is lower than a second threshold (e.g., the second threshold may be lower than the first threshold), the refresh rate control circuit 230 can determine a lower refresh rate, to reduce the power consumption and bandwidth of the DRAM module 120. Furthermore, if the coded temperature CT represents that the current temperature is higher than a threshold, the refresh rate control circuit 230 can determine a higher refresh rate to improve the reliability of the DRAM module 120; and if the coded temperature CT represents that the current temperature is lower than the threshold, the refresh rate control circuit 230 can determine a lower refresh rate to reduce the power consumption and bandwidth of the DRAM module 120.

In one embodiment, the refresh rate control circuit 230 comprises a refresh counter configured to send a refresh command to the command queue 240 based on the refresh rate determined by the refresh rate control circuit 230. Specifically, if the current refresh rate corresponds to one hundred clock cycles, every time a counter value of the refresh counter reaches one hundred, the refresh counter will send a refresh command to the command queue 240, then the refresh counter is reset to restart counting from zero. Then, if the bit error rate increases and the refresh rate control circuit 230 determines a higher refresh rate corresponding to ninety clock cycles, the refresh counter can update the internal threshold, and every time the refresh counter reaches ninety, the refresh counter will send a refresh command to the command queue 240, then the refresh counter is reset to restart counting from zero; and if the bit error rate decreases and the refresh rate control circuit 230 determines a lower refresh rate corresponding to one hundred and ten clock cycles, the refresh counter can update the internal threshold, and every time the refresh counter reaches one hundred and ten, the refresh counter will send a refresh command to the command queue 240, then the refresh counter is reset to restart counting from zero.

Then, after the refresh command generated by the refresh rate control circuit 230 is inputted into the command queue 240, the refresh command can be sent to the DRAM module 120 after all the previous commands are processed, or the refresh command can be sent to the DRAM module 120 with priority after internal arbitration. In addition, after receiving the refresh command from the DRAM controller 110, the DRAM module 120 refreshes the memory cells within the memory array 126 in an appropriate time, that is the control circuit 124 of the DRAM module 120 reads each memory cell and rewrites it, for restoring the charge on a capacitor of the memory cell to its original level.

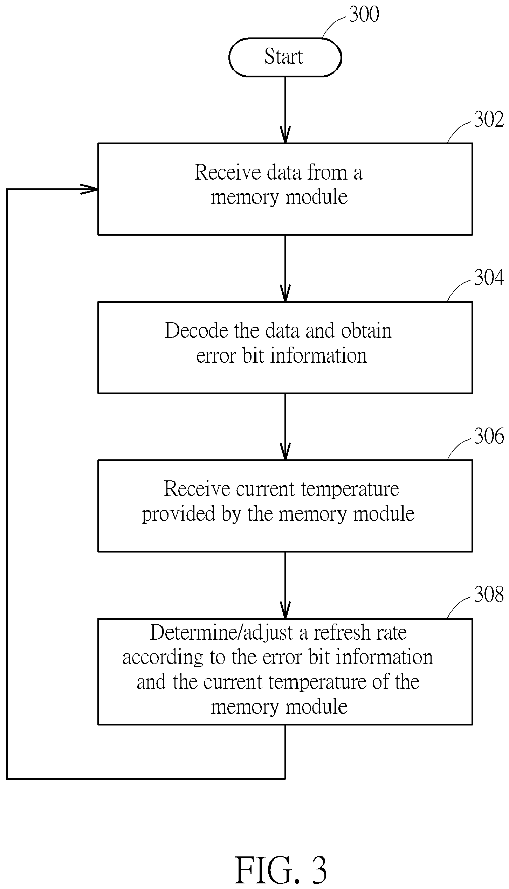

FIG. 3 is a flowchart of a control method of the memory system 100 according to one embodiment of the present invention. Referring to the above embodiments, the flowchart of the control method is described as follows.

Step 300: the flow starts.

Step 302: receive data from a memory module.

Step 304: decode the data and obtain error bit information.

Step 306: receive current temperature provided by the memory module.

Step 308: determine/adjust a refresh rate according to the error bit information and the current temperature of the memory module. Then the flow goes back to Step 302.

Briefly summarized, in the memory system of the present invention, by referring to the current bit error counts or the current bit error rate and the temperature to adaptively control the refresh rate, the memory system can achieve the most suitable performance in terms of reliability, bandwidth and power consumption.

Those skilled in the art will readily observe that numerous modifications and alterations of the device and method may be made while retaining the teachings of the invention. Accordingly, the above disclosure should be construed as limited only by the metes and bounds of the appended claims.

The present invention may also be defined by means of the following numbered clauses.
1. A memory controller, comprising:
   a decoder, configured to receive and decode data from a memory module to generate decoded data;
   an error counter, coupled to the decoder, configured to generate error bit information of the data; and
   a refresh rate control circuit, coupled to the error counter, configured to determine a refresh rate of the memory module according to the error bit information.
2. The memory controller of clause 1, wherein the error bit information is an accumulated number of error bits of the data in a past period of time, or the error bit information is a bit error rate of the data, or the error bit information indicates which level the error bits of the data belongs to.
3. The memory controller of clause 1, wherein the refresh rate control circuit is configured to determine the refresh rate of the memory module according to the error bit information and a current temperature of the memory module.
4. The memory controller of clause 1, wherein the refresh rate control circuit is configured to increase the refresh rate of the memory module if the error bit information indicates that an error bit count or a bit error rate of the data is greater than a first threshold, and the refresh rate control circuit is configured to decrease the refresh rate of the memory module if the error bit information indicates that the error bit count or the bit error rate of the data is lower than a second threshold.
5. The memory controller of clause 1, wherein the refresh rate control circuit comprises a refresh counter, wherein the refresh rate control circuit determines an internal threshold of the refresh counter according to the error bit information, and the refresh counter outputs a refresh command to a command queue when an counter value of the refresh counter reaches the internal threshold.
6. The memory controller of clause 5, wherein the refresh rate control circuit is configured to decrease the internal threshold of the refresh counter if the error bit information indicates that an error bit count or a bit error rate of the data is greater than a first threshold, and the refresh rate control circuit is configured to increase the internal threshold of the refresh counter if the error bit information indicates that the error bit count or the bit error rate of the data is lower than a second threshold.
7. The memory controller of clause 1, wherein the memory controller is a dynamic random access memory (DRAM) controller, and the memory module is a DRAM module.
8. A control method of a memory system, comprising:
   receiving data from a memory module;
   decoding the data to generate decoded data;
   generating error bit information according to the data and the decoded data;
      and
   determining a refresh rate of the memory module according to the error bit information.
9. The control method of clause 8, wherein the error bit information is an accumulated number of error bits of the data in a past period of time, or the error bit information is a bit error rate of the data, or the error bit information indicates which level the error bits of the data belongs to.
10. The control method of clause 8, wherein the step of determining the refresh rate of the memory module according to the error bit information comprises:
   determining the refresh rate of the memory module according to the error bit information and a current temperature of the memory module.
11. The control method of clause 8, wherein the step of determining the refresh rate of the memory module according to the error bit information comprises:
   increasing the refresh rate of the memory module if the error bit information indicates that an error bit count or a bit error rate of the data is greater than a first threshold; and
   decreasing the refresh rate of the memory module if the error bit information indicates that the error bit count or the bit error rate of the data is lower than a second threshold.
12. The control method of clause 8, wherein the memory system is a dynamic random access memory (DRAM) system.
13. A memory system, comprising:
   a memory module; and
   a memory controller, configured to access the memory module, wherein the memory controller comprises:
      a decoder, configured to receive and decode data from the memory module to generate decoded data;
      an error counter, coupled to the decoder, configured to generate error bit information of the data; and
      a refresh rate control circuit, coupled to the error counter, configured to determine a refresh rate of the memory module according to the error bit information.
14. The memory system of clause 13, wherein the error bit information is an accumulated number of error bits of the data in a past period of time, or the error bit information is a bit error rate of the data, or the error bit information indicates which level the error bits of the data belongs to.
15. The memory system of clause 13, wherein the refresh rate control circuit is configured to determine the refresh rate of the memory module according to the error bit information and a current temperature of the memory module.
16. The memory system of clause 13, wherein the refresh rate control circuit is configured to increase the refresh rate of the memory module if the error bit information indicates that an error bit count or a bit error rate of the data is greater than a first threshold, and the refresh rate control circuit is configured to decrease the refresh rate of the memory module if the error bit information indicates that the error bit count or the bit error rate of the data is lower than a second threshold.
17. The memory controller of clause 13, wherein the memory controller is a dynamic random access memory (DRAM) controller, and the memory module is a DRAM module.

## Claims

1. A memory controller (110), comprising:
a decoder (210), configured to receive and decode data from a memory module (120) to generate decoded data;
an error counter (220), coupled to the decoder (210), configured to generate error bit information of the data; and
a refresh rate control circuit (230), coupled to the error counter (220), configured to determine a refresh rate of the memory module (120) according to the error bit information.

2. The memory controller (110) of claim 1, wherein the error bit information is an accumulated number of error bits of the data in a past period of time, or the error bit information is a bit error rate of the data, or the error bit information indicates which level the error bits of the data belongs to.

3. The memory controller (110) of claim 1, wherein the refresh rate control circuit (230) is configured to determine the refresh rate of the memory module (120) according to the error bit information and a current temperature of the memory module (120).

4. The memory controller (110) of claim 1, wherein the refresh rate control circuit (230) is configured to increase the refresh rate of the memory module (120) if the error bit information indicates that an error bit count or a bit error rate of the data is greater than a first threshold, and the refresh rate control circuit (230) is configured to decrease the refresh rate of the memory module (120) if the error bit information indicates that the error bit count or the bit error rate of the data is lower than a second threshold.

5. The memory controller (110) of claim 1, wherein the refresh rate control circuit (230) comprises a refresh counter, wherein the refresh rate control circuit (230) determines an internal threshold of the refresh counter according to the error bit information, and the refresh counter outputs a refresh command to a command queue when an counter value of the refresh counter reaches the internal threshold.

6. The memory controller (110) of claim 5, wherein the refresh rate control circuit (230) is configured to decrease the internal threshold of the refresh counter if the error bit information indicates that an error bit count or a bit error rate of the data is greater than a first threshold, and the refresh rate control circuit (230) is configured to increase the internal threshold of the refresh counter if the error bit information indicates that the error bit count or the bit error rate of the data is lower than a second threshold.

7. The memory controller (110) of claim 1, wherein the memory controller (110) is a dynamic random access memory, DRAM, controller (110), and the memory module (120) is a DRAM module (120).

8. A control method of a memory system (100), comprising:
receiving data from a memory module (120);
decoding the data to generate decoded data;
generating error bit information according to the data and the decoded data;
and
determining a refresh rate of the memory module (120) according to the error bit information.

9. The control method of claim 8, wherein the error bit information is an accumulated number of error bits of the data in a past period of time, or the error bit information is a bit error rate of the data, or the error bit information indicates which level the error bits of the data belongs to.

10. The control method of claim 8, wherein the step of determining the refresh rate of the memory module (120) according to the error bit information comprises:
determining the refresh rate of the memory module (120) according to the error bit information and a current temperature of the memory module (120).

11. The control method of claim 8, wherein the step of determining the refresh rate of the memory module (120) according to the error bit information comprises:
increasing the refresh rate of the memory module (120) if the error bit information indicates that an error bit count or a bit error rate of the data is greater than a first threshold; and
decreasing the refresh rate of the memory module (120) if the error bit information indicates that the error bit count or the bit error rate of the data is lower than a second threshold.

12. A memory system (100), comprising:
a memory module (120); and
a memory controller (110), configured to access the memory module (120), wherein the memory controller (110) comprises:
a decoder (210), configured to receive and decode data from the memory module (120) to generate decoded data;
an error counter (220), coupled to the decoder (210), configured to generate error bit information of the data; and
a refresh rate control circuit (230), coupled to the error counter (220), configured to determine a refresh rate of the memory module (120) according to the error bit information.

13. The memory system (100) of claim 12, wherein the error bit information is an accumulated number of error bits of the data in a past period of time, or the error bit information is a bit error rate of the data, or the error bit information indicates which level the error bits of the data belongs to.

14. The memory system (100) of claim 12, wherein the refresh rate control circuit (230) is configured to determine the refresh rate of the memory module (120) according to the error bit information and a current temperature of the memory module (120).

15. The memory system (100) of claim 12, wherein the refresh rate control circuit (230) is configured to increase the refresh rate of the memory module if the error bit information indicates that an error bit count or a bit error rate of the data is greater than a first threshold, and the refresh rate control circuit (230) is configured to decrease the refresh rate of the memory module if the error bit information indicates that the error bit count or the bit error rate of the data is lower than a second threshold.
